# EUROPEAN PATENT APPLICATION

(11) **EP 4 589 638 A1**
(43) Date of publication of application: **23.07.2025**
(21) Application number: 23879667.6
(22) Date of filing: 10.10.2023
(51) Int. Cl.: H01L 21/50, H01L 21/60, H01L 33/48

(54) **LIFTING METHOD AND RECEIVING SUBSTRATE**

(30) Priority: 21.10.2022 JP 2022168946
(71) Applicant: SHIN-ETSU CHEMICAL CO., LTD., Tokyo 1000005 (JP)
(72) Inventor: TOYOSHIMA, Takeharu, Annaka-shi, Gunma 379-0224 (JP); OGAWA, Yoshinori, Tokyo 100-0005 (JP); KONDO, Kazunori, Tokyo 100-0005 (JP); OZAI, Toshiyuki, Annaka-shi, Gunma 379-0224 (JP)
(74) Representative: Meissner Bolte Partnerschaft mbB
(86) International application number: PCT/JP2023/036788
(87) International publication number: WO 2024/085024

(57) **Abstract**

The present invention is a LIFT method for transferring a microstructure formed on a supply substrate to a receiving substrate by laser lift-off. A face of the microstructure facing the receiving substrate has a recess so that an outer region of the face is higher than an inner region of the face. A face of the receiving substrate to which the microstructure is to be transferred has a resin layer. The laser lift-off is performed with the resin layer in contact with or in proximity to a bottom face of the recess of the microstructure. This can provide a LIFT method that allows for transfer of microstructures with recesses to a receiving substrate by laser lift-off without causing damages on the microstructures.

## Description

### TECHNICAL FIELD

The present invention relates to a LIFT (Laser-Induced Forward Transfer) method for transferring relatively fragile microstructures, such as mini light-emitting diodes (hereinafter also referred to as "mini-LED") and micro light-emitting diodes (hereinafter also referred to as "micro-LED") having protrusions and recesses such as solder particles, from a supply substrate to a receiving substrate by laser lift-off (hereinafter also referred to as "LLO") without damaging the microstructures. The present invention also relates to a receiving substrate capable of receiving microstructures by laser lift-off without damaging the microstructure.

### BACKGROUND ART

In recent years, with the miniaturization of semiconductor devices, the technique of transferring microstructures using adhesive resins has been attracting attention as a means for assembling electric/electronic applied products using semiconductor devices. In particular, the technology for producing LED display, for applications such as signage, televisions, medical use, automotive use, and smartphones, by virtue of the transfer of a large number of mini LEDs (LED devices with a short side length of 100 µm or more up to several hundred micrometers) or micro-LEDs (LED devices with a short side length of 100 µm or less, or even 50 µm or less), amounting to tens of thousands at a time, has been actively developed.

To date, methods have been developed for transferring microstructures such as micro-LEDs by virtue of using a silicone adhesive cured product as a donor substrate or a transfer stamp material, as well as for mounting the microstructures onto a circuit board (Patent Document 1).

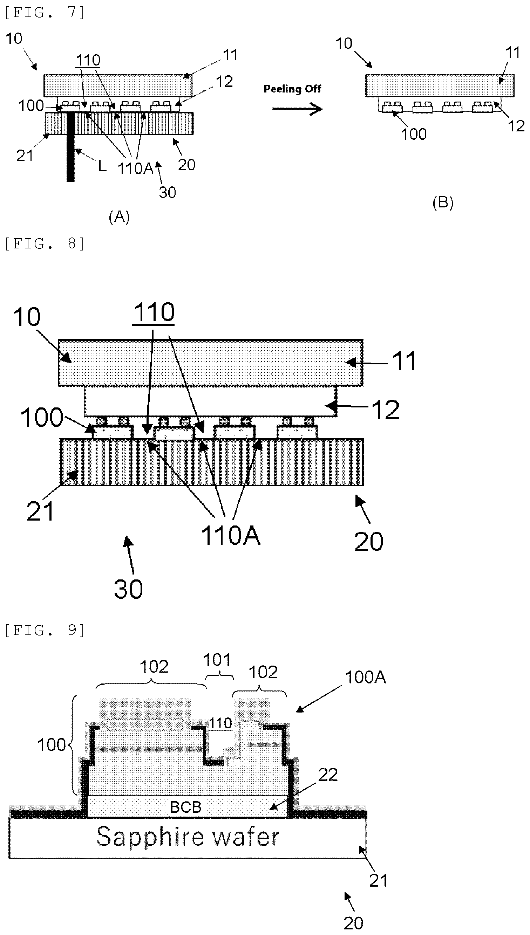

On the other hand, since semiconductor devices generally have electrodes at both ends of the MESA region, they have, although very small, protrusions and recesses. FIG. 9 schematically shows a supply substrate with an example of a typical semiconductor device. In a supply substrate 20 shown in FIG. 9, a semiconductor device 100 is bonded onto a sapphire wafer 21 with a benzocyclobutene (BCB) adhesive layer 22. A face 100A of the semiconductor device 100 opposite the face in contact with the BCB adhesive layer 22 has a recess 110 so that an outer region 102 of the face 100A becomes higher than an inner region 101 of the face 100A.

This, however, results in a defect of breakage of mini-LED devices, which are larger in size compared to micro-LED devices, during the LLO process upon transferring the devices from the supply substrate to the receiving substrate. In addition, since red LED devices are formed by using a group of elements different from those of blue or green LED devices, the red LED devices have a disadvantage of being relatively fragile and susceptible to breakage. Therefore, there have also been breakage of red LED devices during the LLO process.

In addition, a method using a conductive adhesive has been known for electrically connecting transferred microstructures such as LED devices with a circuit board. However, this connecting method faces challenges in keeping up with the further miniaturization of semiconductor devices due to the high positional accuracy required when mounting microstructures and due to the limitations in the miniaturization of conductive fillers. Furthermore, when microstructures such as semiconductor devices generate heat or emit light, the adhesive resin components degrade, making it difficult to achieve long-term reliability. In light of such circumstances, attention is currently focused on the solder process. This technique involves using a semiconductor device with bumps, in which solder particles (hereinafter also referred to as bumps) are pre-mounted on the electrodes of the device. After mounting the devices onto the circuit board, a reflow process is performed to melt the solder particles and integrate the devices into the circuit. By adjusting the amount of solder, this technique can accommodate the trend toward miniaturization. Additionally, the self-alignment effect, an effect of correcting positional misalignment, upon melting the solder particles, allows for greater tolerance in positional accuracy in mounting. Moreover, since the melted solder itself serves as an adhesive, degradation over time is relatively suppressed.

However, because of the formation of bumps, the bump portion is raised as a protrusion. In order to transfer such devices, the resin layer of the donor substrate is required to receive the device surface with protrusions; however, there has been an event that the devices break due to the impact of the LLO.

### CITATION LIST

### PATENT LITERATURE

Patent Document 1: JP 2021-34610 A

### SUMMARY OF INVENTION

### TECHNICAL PROBLEM

There has been a demand for methods for transferring, in addition to the microstructures such as blue and green LEDs having been conventionally studied, microstructures with steps such as bumps, as well as fragile microstructures susceptible to damage including red LEDs, from a supply substrate to a receiving substrate by LLO without causing damages on the microstructures.

The present invention has been made to solve the above problems, and provides a LIFT method that enables transfer of microstructures with recesses to a receiving substrate by laser lift-off without causing damages on the microstructures. The present invention also provides a receiving substrate capable of receiving the microstructures by laser lift-off without causing damages on the microstructures.

### SOLUTION TO PROBLEM

In order to solve the above problems, the present invention provides a LIFT method for transferring a microstructure formed on a supply substrate to a receiving substrate by laser lift-off,
wherein a face of the microstructure facing the receiving substrate has a recess so that an outer region of the face is higher than an inner region of the face,
a face of the receiving substrate to which the microstructure is to be transferred has a resin layer, and
the laser lift-off is performed with the resin layer in contact with or in proximity to a bottom face of the recess of the microstructure.

According to such a LIFT method, by performing laser lift-off with the resin layer in contact with or in proximity to the bottom face of the recess of the microstructure, the impact applied to the microstructure during laser lift-off is alleviated as the impact is dispersed to and absorbed by the resin layer. In this manner, it is possible to transfer the microstructure from the supply substrate to the receiving substrate without causing damages on the microstructure. Therefore, the LIFT method of the present invention is capable of performing the transfer of the microstructure by laser lift-off without causing damages on the microstructure even when the microstructure is a fragile microstructure, such as a red LED device that is fragile and susceptible to breakage or an LED device with an uneven surface such as bumps.

The outer region of the microstructure may have an electrode or a bump.

According to the LIFT method of the present invention, even a microstructure having, for example, an electrode or a bump in the outer region can be transferred without causing damages on the microstructure.

The inner region of the microstructure may be a MESA region.

The inner region of the microstructure may be, but not particularly limited to, a MESA region.

For example, the microstructure may be one or more LED devices selected from red LED, blue LED, and green LED.

The microstructure as the target of transfer in the present invention is not limited as long as it has a recess. However, the microstructure of the present invention may be an LED device, such as red LED, blue LED, or green LED.

The resin layer may be provided by forming the resin layer by virtue of at least one curing reaction selected from the group consisting of radical curing reaction, cationic curing reaction, anionic curing reaction, addition curing reaction and condensation curing reaction.

The resin layer may be formed, for example, by virtue of at least one curing reaction selected from the group consisting of radical curing reaction, cationic curing reaction, anionic curing reaction, addition curing reaction and condensation curing reaction.

For example, the supply substrate and the receiving substrate may be bonded to each other and pressed to deform the resin layer so that the resin layer is in contact with or in proximity to the bottom face of the recess of the microstructure.

For example, the resin layer may be brought into contact with or in proximity to the bottom face of the recess of the microstructure by applying a pressure.

A flexible or flowable resin layer is preferably used as the resin layer.

With such a resin layer, the resin layer may be easily brought into contact with or in proximity to the bottom face of the recess of the microstructure.

In this case, a resin layer having a storage elastic modulus of 1 to 300 kPa at 25°C is preferably used as the resin layer.

With such a resin layer, the resin layer may be more easily brought into contact with or in proximity to the bottom face of the recess of the microstructure.

The present invention further provides a receiving substrate for receiving a microstructure formed on a supply substrate transferred by laser lift-off,
wherein the receiving substrate comprises a resin layer on a face to which the microstructure is to be transferred,
a face of the microstructure facing the receiving substrate has a recess so that an outer region of the face is higher than an inner region of the face, and
the resin layer is to be deformed by bonding the supply substrate and the receiving substrate to each other and pressing the supply substrate and the receiving substrate.

With such a receiving substrate, since the resin layer is to be deformed by bonding the supply substrate and the receiving substrate to each other and pressing the supply substrate and the receiving substrate, the impact applied to the microstructure during laser lift-off is alleviated as the impact is dispersed to and absorbed by the resin layer. As a result, the microstructure can be received from the supply substrate without causing damages on the microstructure. Therefore, even when the microstructure is a fragile microstructure, such as a red LED device that is fragile and susceptible to breakage or an LED device with an uneven surface such as bumps, the receiving substrate of the present invention can receive the microstructure by laser lift-off transfer without causing damages on the microstructure.

The resin layer is to be deformed preferably in an amount sufficient for the resin layer to be in contact with or in proximity to a bottom face of the recess of the microstructure.

The receiving substrate with such a resin layer can more reliably prevent damages on the microstructure.

In this case, the resin layer is preferably a resin layer having a storage elastic modulus of 1 to 300 kPa at 25°C.

The receiving substrate with such a resin layer can further reliably prevent damages on the microstructure.

### ADVANTAGEOUS EFFECTS OF INVENTION

As described above, according to the LIFT method of the present invention, microstructures with recesses can be transferred to a receiving substrate by virtue of laser lift-off without causing damages of the microstructures. This method of the present invention is particularly applicable to production process of LED displays for applications such as signage, televisions, medical use, automotive use, and smartphones.

Further, the receiving substrate of the present invention is capable of receiving microstructures with recesses by virtue of laser lift-off transfer without causing damages on the microstructures.

### BRIEF DESCRIPTION OF DRAWINGS

FIG. 1 is a schematic diagram showing an example of a receiving substrate of the present invention;
FIG. 2 illustrates schematic diagrams each showing an example of a receiving substrate of the present invention in a different aspect;
FIG. 3 is a schematic diagram showing an example of a LIFT method of the present invention;
FIG. 4 is a schematic diagram showing an example of a supply substrate that can be used in a LIFT method of the present invention;
FIG. 5 is a schematic diagram showing another example of a supply substrate that can be used in the LIFT method of the present invention;
FIG. 6 is a schematic diagram showing a step of one embodiment of the LIFT method of the present invention;
FIG. 7 is a schematic diagram showing another step of one embodiment of the LIFT method of the present invention;
FIG. 8 is a schematic diagram showing a LIFT method of a comparative example; and
FIG. 9 is a schematic diagram of a supply substrate with an example of a typical semiconductor device.

### DESCRIPTION OF EMBODIMENTS

As described above, there have been demands for the development of a LIFT method that enables transfer of microstructures with recesses to a receiving substrate by laser lift-off without causing damages on the microstructures, as well as a receiving substrate capable of receiving microstructures by virtue of laser lift-off without causing damages on the microstructures.

The present inventors have intensively studied the above problems. As a result, the present inventors found that microstructures with recesses can be transferred onto a receiving substrate without causing damages on the microstructures by providing a resin layer on a face of the receiving substrate to which the microstructures are to be transferred, and performing laser lift-off with the resin layer in contact with or in proximity to the bottom faces of the recesses of the microstructures. With this finding, the present inventors have completed the present invention.

Specifically, the present invention is a LIFT method for transferring a microstructure formed on a supply substrate to a receiving substrate by laser lift-off,
wherein a face of the microstructure facing the receiving substrate has a recess so that an outer region of the face is higher than an inner region of the face,
a face of the receiving substrate to which the microstructure is to be transferred has a resin layer, and
the laser lift-off is performed with the resin layer in contact with or in proximity to a bottom face of the recess of the microstructure.

The present invention is also a receiving substrate for receiving a microstructure formed on a supply substrate transferred by laser lift-off,
wherein the receiving substrate comprises a resin layer on a face to which the microstructure is to be transferred,
a face of the microstructure facing the receiving substrate has a recess so that an outer region of the face is higher than an inner region of the face, and
the resin layer is to be deformed by bonding the supply substrate and the receiving substrate to each other and pressing the supply substrate and the receiving substrate.

The present invention is described below in detail; however, the present invention is not limited to thereto.

### [Receiving Substrate]

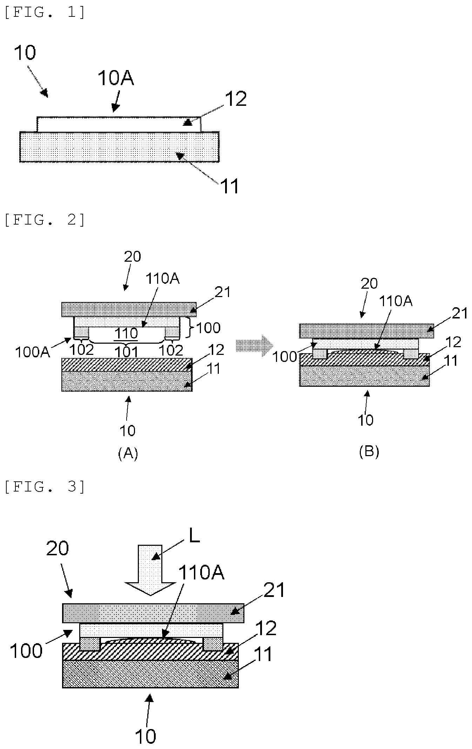

FIG. 1 schematically illustrates an example of a receiving substrate according to the present invention. However, the receiving substrate of the present invention is not limited to the example shown in FIG. 1.

The receiving substrate 10 shown in FIG. 1 includes a resin layer 12 on a support substrate 11. A face 10A of the receiving substrate 10 on which the resin layer 12 is provided is the face to which the microstructure is to be transferred as described below.

As shown in FIG. 2, the resin layer 12 deforms when a supply substrate 20 and the receiving substrate 10 are bonded to each other and a pressure is applied on them.

It should be noted that the supply substrate 20 shown in FIG. 2 is the same as the supply substrate 20 described with reference to FIG. 9. Specifically, the supply substrate 20 includes a support substrate 21 and a microstructure 100 supported by the support substrate 21. The face 100A of the microstructure 100 opposite the face facing the support substrate 21 has a recess 110 so that an outer region 102 of the face 100A is higher than an inner region 101 of the face 100A. The embodiment of the supply substrate 20 is described later.

With such a receiving substrate 10, since the resin layer 12 deforms when the supply substrate 20 and the receiving substrate 10 are bonded to each other and pressed, the impact applied to the microstructure 100 during laser lift-off is alleviated as the impact is dispersed to and absorbed by the resin layer 12. As a result, the microstructure 100 can be received from the supply substrate 20 without causing damages on the microstructure 100. Therefore, even when the microstructure 100 is a fragile microstructure, such as a red LED device that is fragile and susceptible to breakage or an LED device with an uneven surface such as bumps, the receiving substrate 10 of the present invention can receive the microstructure 100 by virtue of laser lift-off transfer without causing damages on the microstructure 100.

The resin layer 12 of the receiving substrate 10 preferably deforms in an amount sufficient for the resin layer 12 to be in contact with or in proximity to the bottom face 110A of the recess 110 of the microstructure 100, for example, as shown in FIG. 2B.

The receiving substrate 10 with such a resin layer 12 can more reliably prevent damages on the microstructure 100.

The receiving substrate 10 can be formed, for example, by applying a precursor of the resin layer 12 (e.g., a silicone-based gel composition) onto the support substrate 11, followed by curing the precursor.

Examples of the support substrate 11 used for the receiving substrate 10 include synthetic quartz glass substrates and float glass. In particular, from the viewpoint of flatness and the viewpoint of transfer of the microstructure 100 with protrusions and recesses (recess 110) such as bumps, a synthetic quartz glass substrate is preferable because the support substrate 10 is required to have transparency so that, after the bonding step described later, it is possible to confirm whether the resin layer 12 is in contact with or in proximity to the bottom face 110A of the recess 110.

Further, the size of the support substrate 11 used for the receiving substrate 10 is preferably equal to or larger than the diameter of the supply substrate 20 used. Specifically, when using a sapphire substrate with an outer diameter of 10.16 cm (4 inches) as the supply substrate 20, a receiving substrate 10 with an outer diameter of 10.16 to 20.32 cm (4 to 8 inches) can be used.

For reliable transfer of some or all of a plurality of microstructures 100 from the supply substrate 20 to the receiving substrate 10, it is preferable that, during bonding of the plurality of microstructures 100 formed on one face of the supply substrate 20 with the receiving substrate 10 in which the resin layer 12 is provided on the support substrate 11, each microstructure 100 be temporarily and uniformly pre-secured to the resin layer 12 of the receiving substrate 10.

To precisely pre-secure the microstructure 100 as described above, the support substrate 11 used for the receiving substrate 10 preferably has a power spectral density of not more than 10¹² nm⁴ at a spatial frequency of not less than 1 mm⁻¹, as measured by a white light interferometry with a pixel count of 1240 × 1240 for a 6.01 mm × 6.01 mm region. In particular, when a micro-LED is used as the microstructure 100, considering the distance between the individual microstructures 100, the support substrate 11 preferably has a power spectral density of not more than 10⁹ nm⁴ at a spatial frequency in a range of not less than 10 mm⁻¹ to not more than 50 mm⁻¹, as measured by a white light interferometry with a pixel count of 1240 × 1240 for a 6.01 mm × 6.01 mm region.

Moreover, to precisely pre-secure the microstructure 100 to the receiving substrate 10, the support substrate 11 used for the receiving substrate 10 preferably has a small thickness variation. For example, thickness variation (TTV) measured by a wavelength conversion Fizeau flatness tester, which is available from Mizojiri Optical Co., Ltd., is preferably not more than 2 µm, more preferably not more than 1 µm, and further preferably not more than 0.5 µm.

The resin layer 12 is preferably flexible or flowable. More preferably, the resin layer 12 is a resin layer having a storage elastic modulus of 1 to 300 kPa at 25°C. Such a resin layer 12 may be, but not limited to, for example, a silicone-based gel layer.

The silicone-based gel layer can be obtained, for example, by curing a silicone-based gel composition. However, the curing reaction used for the curing is preferably at least one selected from addition curing reaction, radical curing reaction such as photo-radical polymerization reaction or thermal radical polymerization reaction, cationic curing reaction, anionic curing reaction, and condensation curing reaction. Among these, addition curing reaction, photo-radical polymerization reaction, and thermal radical polymerization reaction are preferable because of easiness of resin design and easiness in curing. The silicone-based gel layer can be, for example, a curable resin layer that can be further cured. In this case, the silicone-based gel composition may be a two-stage curing silicone gel composition.

To coat the support substrate 11 with the silicone-based gel composition, for example, the silicone-based gel composition can be applied onto the support substrate 11 by spin coating, preferably at a thickness of 1 to 500 µm, more preferably 5 to 200 µm, and further preferably 10 to 10 µm. The thickness can be determined as appropriate based on the shape and thickness of the microstructure 100 to be transferred. The coating may be applied with respect to the entire surface of the support substrate 11, or, for example, to ensure handling property, excessive silicone-based gel composition may be washed off by edge rinsing or the like to expose a part of the outer periphery of the support substrate 11. Alternatively, slit coating or screen printing may be performed to apply the silicone-based gel composition so as to achieve a specific thickness or shape.

Furthermore, in order to achieve improved adhesion or secure bonding at the interface between the support substrate 11 and the resin layer 12, a support substrate 11 treated with a primer in advance may be used.

After the coating step, the resin layer 12 can be formed under curing conditions suitable for the silicone composition used. For example, for the curing by addition curing reaction, the curing is performed preferably in a heating furnace under an environment at 20 to 200°C for 5 to 90 minutes. For the curing by photo-radical polymerization reaction, the composition is preferably subjected to UV irradiation under a nitrogen atmosphere at an irradiance of such as 50 to 3000 mW/cm² and a total optical dose of 100 to 20000 mJ/cm² using light of, as a standard, 365 nm.

### [LIFT Method]

Next, a LIFT method of the present invention is described with reference to FIG. 3, while again referring to FIG. 1 and FIG. 2 as well. However, the present invention is not limited to the illustrated embodiments.

FIG. 3 schematically illustrates an example of the LIFT method of the present invention.

The LIFT method of the present invention is a LIFT method for transferring the microstructure 100 formed on the supply substrate 20 to the receiving substrate 10 by laser lift-off.

Similar to the configuration shown in FIG. 2, the microstructure 100 formed on the supply substrate 20 has the face 100A facing the receiving substrate 10, and the face 100A has the recess 110 so that the outer region 102 of the face 100A is higher than the inner region 101 of the face 100A. Further, similar to the configuration shown in FIG. 1, the face 10A of the receiving substrate 10 to which the microstructure is to be transferred has the resin layer 12.

In the LIFT method of the present invention, as shown in FIG. 3, laser lift-off is performed by irradiating the back side of the support substrate 21 of the supply substrate 20 with laser L in a state where the resin layer 12 is in contact with or in proximity to the bottom face 110A of the recess 110 of the microstructure 100. The details of the laser lift-off are described later.

The state where the resin layer 12 is in contact with the bottom face 110A of the recess 110 of the microstructure 100 is not limited to a state where the entire bottom face 110A is in contact with the resin layer 12, but also includes a state where only a portion of the bottom face 110A is in contact with the resin layer 12 as shown in FIG. 3. In the state where the resin layer 12 is in contact with the bottom face 110A of the recess 110 of the microstructure 100, the distance (minimum distance) between the bottom face 110A of the recess 110 of the microstructure 100 and the resin layer 12 is 0 µm.

The state where the resin layer 12 is in proximity to the bottom face 110A of the recess 110 of the microstructure 100 means that there is a minute gap, which can alleviate the impact to be applied to the microstructure 100 during laser lift-off, between the bottom face 110A and the resin layer 12. Specifically, the state of being in proximity to each other can refer to, for example, a state where the gap between the bottom face 110A and the resin layer 12 can be greater than 0 µm but not more than 1 µm, preferably greater than 0 µm but not more than 0.5 µm. In another aspect, when the depth of the recess 110 of the microstructure 100 is defined as "1", the gap between the bottom face 110A and the resin layer 12 can be greater than "0" but not more than "0.1", preferably greater than "0" but not more than "0.05".

The state where the resin layer 12 is in contact with or in proximity to the bottom face 110A of the recess 110 of the microstructure 100 may also be referred to as a state where the resin layer 12 is "approximately in contact with" the bottom face 110A. The state where the resin layer 12 is approximately in contact with the bottom face 110A can refer to a state where the gap between the bottom face 110A and the resin layer 12 is not less than 0 µm but not more than 1 µm. In another aspect, when the depth of the recess 110 of the microstructure 100 is defined as "1," the state where the resin layer 12 is approximately in contact with the bottom face 110A can refer to a state where the gap between the bottom face 110A and the resin layer 12 is not less than "0" but not more than "0.1".

With such a LIFT method, by performing laser lift-off with the resin layer 12 in contact with or in proximity to the bottom face 110A of the recess 110 of the microstructure 100, the impact applied to the microstructure 100 during laser lift-off is alleviated as the impact is dispersed to and absorbed by the resin layer 12. In this manner, it is possible to transfer the microstructure 100 from the supply substrate 20 to the receiving substrate 10 without causing damages on the microstructure 100. Therefore, according to the LIFT method of the present invention, the transfer of the microstructure 100 can be performed by laser lift-off without causing damages on the microstructure 100 even when the microstructure 100 is a fragile microstructure, such as a red LED device that is fragile and susceptible to breakage or an LED device with an uneven surface such as bumps.

Herein after, the receiving substrate and the supply substrate used for the LIFT method of the present invention are described.

### [Receiving Substrate]

For example, the receiving substrate 10 of the present invention described above may be used as the receiving substrate 10.

To prepare the receiving substrate 10, the resin layer 12 may be formed by, for example, at least one curing reaction selected from the group consisting of radical curing reaction, cationic curing reaction, anionic curing reaction, addition curing reaction, and condensation curing reaction.

The resin layer 12 is preferably a flexible or flowable resin layer, and more preferably a resin layer having a storage elastic modulus of 1 to 300 kPa at 25°C.

Further details of the receiving substrate 10 can be found in the previous description of the receiving substrate 10 of the present invention.

### [Supply Substrate and Microstructure]

The supply substrate 20 used for the LIFT method of the present invention is a substrate in which the microstructure 100 is formed, as described with reference to FIG. 2. The face 100A of the microstructure 100 facing the receiving substrate 10 has the recess 110 so that the outer region 102 of the face 100A is higher than the inner region 101 of the face 100A.

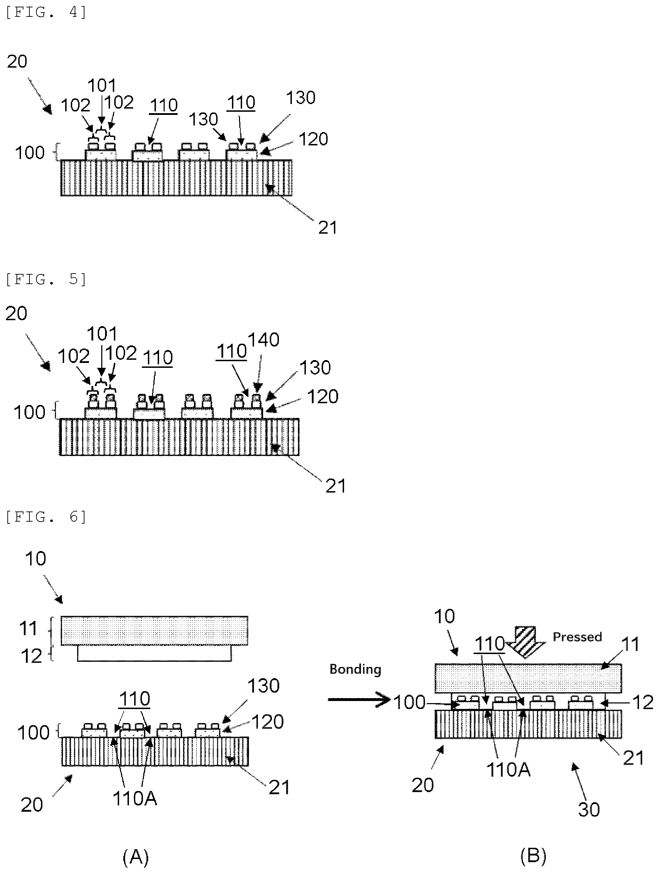

For example, as shown in FIG. 4, the supply substrate 20 may be such that a plurality of microstructures 100 are formed on one face of the support substrate 21, and, in each microstructure 100, electrodes 130 are formed on a device body 120. The region corresponding to the electrodes 130 is the outer region 102, which is higher than the inner region 101. As a result, the recess 110 is formed between the electrodes 130.

In the case of a substrate with bumps, as shown in FIG. 5, a bump 140 is further formed on the electrode 130.

The inner region 101 of the microstructure 100 may be a MESA region.

Examples of the support substrate 21 used for the supply substrate 20 include sapphire substrates, GaAs substrates (gallium arsenide substrates), Si substrates, and SiC substrates, with no specific limitation on the diameter.

Further, examples of the microstructure 100 include devices obtained such that the supply substrate 20 is first given a basic structure as a device by the processes performed during usual semiconductor pre-processes, such as epitaxial growth, ion implantation, wet etching, dry etching, vapor deposition, and electrode formation, followed by separation using common methods, such as blade dicing, dry etching, or laser dicing, that are performed so as to achieve a depth sufficient to isolate the devices.

For example, when the microstructure 100 is an LED device, the supply substrate 20 can be provided as follows. A 4-inch sapphire substrate serving as the support substrate 21 is provided with a buffer layer, followed by formation of an N-type GaN layer having a thickness of 3 µm. Subsequently, a known light-emitting layer structure is provided, followed by stacking of a P-type GaN, thereby preparing an LED epitaxial substrate with a total epitaxial thickness of 4 µm. Thereafter, dry etching is performed to locally expose the N-layer, followed by formation of P-type electrode on the P-layer as well as formation of N-type electrode in contact with the exposed N-layer using known processes. Then, bumps are formed on the electrodes by way of plating, vapor deposition, sputtering, or the like. Then, to separate the LED devices with a predetermined size from each other, laser dicing is performed to achieve at least the depth of the sapphire substrate to ensure complete separation of the LED devices. In this manner, the supply substrate 20 in which LED devices are formed as the microstructure 100 can be obtained.

The microstructure 100 used in the present invention may have an arbitrary size. For example, in the case of power LED, the size of the microstructure 100 is approximately 1 mm square. In addition, the size of the microstructure 100 is approximately 300 µm square for LED devices, approximately 100 µm square for mini-LED, approximately 60 µm square or smaller for micro-LED, and approximately 30 µm square or smaller for ultra-micro-LED.

In the examples shown above, the microstructure 100 is approximately a square; however, the present invention is not limited to this example. For example, in the case of micro-LED, they may have a rectangular shape with one side ranging from 30 to 60 µm and the other side ranging from 10 to 30 µm.

The thickness of the main body of the microstructure 100 depends on the thickness of the epitaxial growth on the support substrate 21 of the supply substrate 20, and is not particularly limited. However, the thickness is preferably about 3 to 10 µm. The thickness of the electrode is not particularly limited but is preferably 2 µm or less, and the thickness of the bump is not particularly limited but is preferably about 1 to 10 µm.

### [Embodiments]

One embodiment of the LIFT method of the present invention is described below with reference to FIG. 6 and FIG. 7. However, the present invention is not limited to the embodiments described below.

The LIFT method according to the embodiment described here includes a bonding step, a transfer step by laser lift-off, and a peeling step.

### [Bonding Step]

The bonding of the plurality of microstructures 100 formed on one face of the supply substrate 20 with the resin layer 12 of the receiving substrate 10 can be performed, for example, as shown in FIG. 6. Specifically, the bonding is performed as follows. It should be noted that in the embodiment described below, a silicone-based gel layer is used as the resin layer 12 of the receiving substrate 10, and a substrate on which the microstructures 100 are formed shown in FIG. 4 is used as the supply substrate 20.

First, as shown in FIG. 6A, positioning of the supply substrate 20 and the receiving substrate 10 is performed. Next, the silicone-based gel layer 12 of the receiving substrate 10 is bonded to the electrodes 130 and the device bodies 120 of the microstructures 100. Then, as shown in FIG. 6B, the receiving substrate 10 is pressed against the supply substrate 20 to deform the silicone-based gel layer 12, so that, as in the state shown in FIG. 2B, the silicone gel layer 12 is in contact with or in proximity to the bottom faces 110A of the recesses 110 of the microstructures 100. In FIG. 6B, the gel of the silicone-based gel layer 12 covers the microstructures 100. The same bonding step is performed also when using the supply substrate 20 of FIG. 5 in which the microstructures 100 with bumps 140 are formed.

The load of pressure applied during the bonding is not particularly limited as long as the plurality of microstructures 100 can be transferred to the silicone-based gel layer 12. However, the bonding is preferably performed by applying a load in the range of 0.05 to 1.0 MPa, more preferably 0.10 to 0.5 MPa. In addition, in order for the silicone-based gel layer 12 to more easily conform the shape of the microstructure 100, mechanical pressing may be accompanied by vacuum decompression or heat application.

Through such a bonding step including pressure application, a lamination substrate 30 shown in FIG. 6B and including the supply substrate 20, and the receiving substrate 10 bonded to the supply substrate 20 is obtained.

After the bonding step, by a laser microscope or the like, it is possible to confirm, through the substrate, that the silicone-based gel layer 12 deforms while following the shapes of the protrusions and recesses due to the presence of the electrodes 130 and the bumps 140 on the microstructure 100, so that the silicone-based gel layer 12 is approximately in contact with the bottom face 110A of the recess 110 of the microstructure 100 with no gap larger than 1 µm between the silicone-based gel layer 12 and the microstructure 100. Since a gel cured product is generally soft and adhesive, as long as the silicone-based gel layer 12 is brought into contact with or into proximity to the bottom faces 110A of the recesses 110 of the microstructures 100 by the bonding step, this state can be maintained also in the LLO step, which is described later, thereby preventing damages on the microstructures 100.

### [Transfer Step by Laser Lift-Off, and Peeling Step]

FIG. 7 shows a transfer step by LLO (laser lift-off).

As shown in FIG. 7A, the lamination substrate 30 obtained in the bonding step is irradiated with pulsed laser L from the face of the supply substrate 20 opposite the face where the microstructure 100 is formed, thereby separating the microstructure 100 from the support substrate 21. After the same laser irradiation is performed to all of the microstructures 100 to be transferred, the support substrate 11 of the receiving substrate 10 and the support substrate 21 of the supply substrate 20 are peeled apart using a jig to obtain the state shown in FIG. 7B. In this way, the microstructures 100 are transferred onto the silicone-based gel layer 12 of the receiving substrate 10.

In the LLO step, for example, when lift-off is performed on a gallium nitride microstructure 100 secured to the support substrate 21, such as a sapphire substrate, by virtue of laser irradiation, such as excimer laser or YAG laser, the portion of the gallium nitride exposed to the laser irradiation dissolves, thus allowing the gallium nitride microstructure 100 to be separated from the supply substrate 20. In this case, particularly in the case of micro-LED, KrF excimer laser is preferable from the viewpoint of reliability of the microstructure 100.

Specifically, by selective laser irradiation, laser ablation is induced at the interface between the selected microstructure 100 and the support substrate 21 of the supply substrate 20. This results in, for example, in the case of the gallium nitride microstructure 100, decomposition of the gallium nitride into metallic gallium and nitrogen, thereby generating a gas, between the selected microstructure 100 and the support substrate 21 of the supply substrate 20. This allows relatively easy separation of the microstructure 100.

On the other hand, since gel materials are generally soft and highly tacky, they can easily adhere to the microstructure 100 that has been separated from the supply substrate 20 and receive the microstructure 100, thereby enabling transfer of the microstructure 100.

Such a transfer method allows successful transfer of the microstructure 100 onto the receiving substrate 10 without causing damages on the microstructure 100 even for the microstructure 100 that is easily damaged, such as a red LED device that is fragile and susceptible to breakage or an LED device with an uneven surface with bumps or the like. This is because, in this method, by bonding the silicone-based gel layer 12 on the receiving substrate 10 to the microstructure 100 while applying a pressure, the gel is deformed so as to conform to the shape of the microstructure 100, and the silicone-based gel layer 12 comes in contact with or in proximity to the bottom face 110A of the recess 110 of the microstructure 100, and then, by performing LLO in this state, the impact applied to the microstructure 100 during LLO is dispersed to and absorbed by the silicone-based gel.

The microstructure 100 thus transferred onto the receiving substrate 10 by this step may be mounted onto the circuit board by virtue of surface cleaning using, for example, an acidic or alkaline cleaning solution or through plasma treatment followed by the desired steps, for example, the step using the transfer stamp material described in Patent Document 1 or the step of retransfer of the microstructure to an polyimide layer.

In other words, the receiving substrate 10 that has received the microstructure 100 that has been transferred by the LIFT method of the present invention may also be used as a supply substrate (donor substrate) in a different step.

### EXAMPLES

Hereinafter, the present invention is specifically described with reference to Examples and Comparative Examples. However, the present invention is not limited to these Examples.

Supply substrates with the following microstructures were provided respectively.

### <Supply Substrate A and Microstructure A>

A sapphire substrate cut into a 1.5 cm square on which blue mini-LED devices measuring 90 × 140 µm, with a total thickness of 19 µm, including a bump height of 7 µm are mounted

### <Supply Substrate B and Microstructure B>

A sapphire substrate cut into a 1.5 cm square on which blue mini-LED devices measuring 90 × 140 µm, with a total thickness of 12 µm are mounted

### <Supply Substrate C and Microstructure C>

A sapphire substrate cut into a 1.5 cm square on which red micro-LED devices measuring 18 × 36 µm, with a total thickness of 5 µm are mounted

Also, as receiving substrates, the following support substrates were provided.

### <Support substrate used for Receiving Substrate>

A synthetic quartz substrate with an outer diameter of 15.24 cm (6 inches), thickness of 1 mm, and thickness variation (TTV) of 0.8 µm

### <Examples 1 to 5>

### [Production of Receiving Substrate]

3g of the thermally curable or photo-curable silicone gel composition shown below was added dropwise onto the support substrate and uniformly applied to the support substrate using a spin coater so as to achieve a film thickness of 30 µm. The silicone-coated support substrate was then subjected to curing under the respective curing conditions described below into a gelling state, thereby producing each receiving substrate having a silicone gel layer as a resin layer.

### [Bonding]

The supply substrate and the receiving substrate were bonded to each other while applying a pressure of 0.5 MPa, ensuring that the microstructures on the supply substrate shown in Table 1 below was in contact with the silicone gel on the receiving substrate. After bonding, a laser microscope was used to confirm that there were no gaps larger than 1 µm between the bottom faces of the recesses in the microstructures and the silicone gel layer.

[LLO]
The microstructure was irradiated with a KrF excimer laser from the back side of the supply substrate to perform LLO. After LLO, the supply substrate was peeled from the receiving substrate, and the transfer rate of the microstructures from the supply substrate to the receiving substrate and the damage rate were evaluated. The results are summarized in Table 1.

### [Measurement of Elastic Modulus]

The dynamic viscoelastic property of the cured silicone-based gel in the present invention was defined by the storage elastic modulus G' at a specific frequency and a specific temperature. The measurement was conducted using an ARES G-II viscoelastic measurement apparatus available from TA Instruments. A silicone resin that has been cured and molded into a 3 cm square at a thickness of 500 µm was placed in the circular measurement unit of the same tester and sandwiched between 20 mm-diameter parallel plates while avoiding air bubbles. The measurement was performed for 10 minutes while keeping the temperature at 25°C, with a strain value of 4% and a frequency of 1 Hz. The value 10 minutes after the start of the measurement was recorded as the storage elastic modulus G'.

### [Silicone Gel Compositions and Curing Conditions]

Silicone 1: a silicone gel composition to be thermally cured at 120°C for 1 hour, the cured product having a storage elastic modulus of 0.2 kPa at 25°C

Silicone 2: a silicone gel composition to be cured by photo-radical curing under nitrogen atmosphere with irradiation of 365 nm UV-LED at 3000 mJ/cm² (irradiance: 100 mW/cm²), the cured product having a storage elastic modulus of 0.2 kPa at 25°C

Silicone 3: a silicone gel composition to be cured by photo-radical curing under nitrogen atmosphere with irradiation of 365 nm UV-LED at 3000 mJ/cm² (irradiance: 100 mW/cm²), the cured product having a storage elastic modulus of 5.3 kPa at 25°C

### <Comparative Examples 1 to 4>

In Comparative Examples 1 to 4, the same transfer method as in the Examples was performed, except that Silicone 4 or Silicone 5 described below was used as the silicone gel composition for the receiving substrate, and that the supply substrates shown in Table 1 were used.

Silicone 4: a silicone rubber composition to be thermally cured at 120°C for 1 hour, the cured product having a storage elastic modulus of 500 kPa at 25°C

Silicone 5: a silicone rubber composition to be thermally cured at 120°C for 1 hour, the cured product having a storage elastic modulus of 3 MPa at 25°C

As shown in FIG. 8, in Comparative Examples, the silicone did not deform, and LLO was performed in a state in which the silicone was neither in contact with nor in proximity to the surfaces of the recesses in the microstructures.

**[Table 1]**

| | Example 1 | Example 2 | Example 3 | Example 4 | Example 5 | Comparative Example 1 | Comparative Example 2 | Comparative Example 3 | Comparative Example 4 |
|---|---|---|---|---|---|---|---|---|---|
| Type of Silicone | Silicone 1 | Silicone 2 | Silicone 2 | Silicone 2 | Silicone 3 | Silicone 4 | Silicone 5 | Silicone 5 | Silicone 5 |
| Storage Elastic Modulus of Silicone (25°C) | 0.2kPa | 0.2kPa | 0.2kPa | 0.2kPa | 5.3kPa | 500kPa | 3MPa | 3MPa | 3MPa |
| Microstructure | Microstructure A | Microstructure A | Microstructure B | Microstructure C | Microstructure B | Microstructure A | Microstructure A | Microstructure B | Microstructure C |
| Presence of Approximate Contact | Yes | Yes | Yes | Yes | Yes | No | No | No | No |
| Transfer Rate [%] | More than 99% | More than 99% | More than 99% | More than 99% | More than 99% | More than 99% | More than 99% | More than 99% | More than 99% |
| Damage Rate [%] | Less than 1% | Less than 1% | Less than 1% | Less than 1% | Less than 1% | 15% | 30% | 5% | 15% |

As clearly shown in the results in Table 1, in Examples 1 to 5 in which LLO was performed with the silicone gel layer in contact with or in proximity to the bottom faces of the recesses in the microstructures, the damage rate during the transfer by laser lift-off was able to be suppressed to be less than 1% even when the transfer rate was more than 99%.

In contrast, in Comparative Examples 1 to 4, the damage rate during the transfer by laser lift-off was 5% or higher because in Comparative Examples 1 to 4, lift-off was performed with the silicone gel layer neither in contact with nor in proximity to the bottom faces of the recesses in the microstructures.

The present description includes the following embodiments.
[1] A LIFT method for transferring a microstructure formed on a supply substrate to a receiving substrate by laser lift-off,
   wherein a face of the microstructure facing the receiving substrate has a recess so that an outer region of the face is higher than an inner region of the face,
   a face of the receiving substrate to which the microstructure is to be transferred has a resin layer, and
   the laser lift-off is performed with the resin layer in contact with or in proximity to a bottom face of the recess of the microstructure.
[2] The LIFT method according to [1], wherein the outer region of the microstructure has an electrode or a bump.
[3] The LIFT method according to [1] or [2], wherein the inner region is a MESA region.
[4] The LIFT method according to any one of [1] to [3], wherein the microstructure is one or more LED devices selected from red LED, blue LED, and green LED.
[5] The LIFT method according to any one of [1] to [4], wherein the resin layer is provided by forming the resin layer by virtue of at least one curing reaction selected from the group consisting of radical curing reaction, cationic curing reaction, anionic curing reaction, addition curing reaction and condensation curing reaction.
[6] The LIFT method according to any one of [1] to [5], wherein the supply substrate and the receiving substrate are bonded to each other and pressed to deform the resin layer so that the resin layer is in contact with or in proximity to the bottom face of the recess of the microstructure.
[7] The LIFT method according to any one of [1] to [6], wherein a flexible or flowable resin layer is used as the resin layer.
[8] The LIFT method according to any one of [1] to [7], wherein a resin layer having a storage elastic modulus of 1 to 300 kPa at 25°C is used as the resin layer.
[9] A receiving substrate for receiving a microstructure formed on a supply substrate transferred by laser lift-off,
   wherein the receiving substrate comprises a resin layer on a face to which the microstructure is to be transferred,
   a face of the microstructure facing the receiving substrate has a recess so that an outer region of the face is higher than an inner region of the face, and
   the resin layer is to be deformed by bonding the supply substrate and the receiving substrate to each other and pressing the supply substrate and the receiving substrate.
[10] The receiving substrate according to [9], wherein the resin layer is to be deformed in an amount sufficient for the resin layer to be in contact with or in proximity to a bottom face of the recess of the microstructure.
[11] The receiving substrate according to [9] or [10], wherein the resin layer is a resin layer having a storage elastic modulus of 1 to 300 kPa at 25°C.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A LIFT method for transferring a microstructure formed on a supply substrate to a receiving substrate by laser lift-off,
wherein a face of the microstructure facing the receiving substrate has a recess so that an outer region of the face is higher than an inner region of the face,
a face of the receiving substrate to which the microstructure is to be transferred has a resin layer, and
the laser lift-off is performed with the resin layer in contact with or in proximity to a bottom face of the recess of the microstructure.

2. The LIFT method according to claim 1, wherein the outer region of the microstructure has an electrode or a bump.

3. The LIFT method according to claim 2, wherein the inner region is a MESA region.

4. The LIFT method according to claim **1,** wherein the microstructure is one or more LED devices selected from red LED, blue LED, and green LED.

5. The LIFT method according to claim 1, wherein the resin layer is provided by forming the resin layer by virtue of at least one curing reaction selected from the group consisting of radical curing reaction, cationic curing reaction, anionic curing reaction, addition curing reaction and condensation curing reaction.

6. The LIFT method according to any one of claims 1 to 5, wherein the supply substrate and the receiving substrate are bonded to each other and pressed to deform the resin layer so that the resin layer is in contact with or in proximity to the bottom face of the recess of the microstructure.

7. The LIFT method according to any one of claims 1 to 5, wherein a flexible or flowable resin layer is used as the resin layer.

8. The LIFT method according to claim 7, wherein a resin layer having a storage elastic modulus of 1 to 300 kPa at 25°C is used as the resin layer.

9. A receiving substrate for receiving a microstructure formed on a supply substrate transferred by laser lift-off,
wherein the receiving substrate comprises a resin layer on a face to which the microstructure is to be transferred,
a face of the microstructure facing the receiving substrate has a recess so that an outer region of the face is higher than an inner region of the face, and
the resin layer is to be deformed by bonding the supply substrate and the receiving substrate to each other and pressing the supply substrate and the receiving substrate.

10. The receiving substrate according to claim 9, wherein the resin layer is to be deformed in an amount sufficient for the resin layer to be in contact with or in proximity to a bottom face of the recess of the microstructure.

11. The receiving substrate according to claim 9 or 10, wherein the resin layer is a resin layer having a storage elastic modulus of 1 to 300 kPa at 25°C.
